# EUROPEAN PATENT SPECIFICATION

(11) **EP 3 415 844 B1**
(45) Date of publication and mention of the grant of the patent: **05.08.2020**
(21) Application number: 17815282.3
(22) Date of filing: 15.06.2017
(51) Int. Cl.: F25B 31/00, F25D 19/00, H01L 23/467, B60H 1/32

(54) **REFRIGERATING UNIT FOR TRANSPORTATION**
KÜHLEINHEIT ZUM TRANSPORT
UNITE FRIGORIFIQUE POUR LE TRANSPORT

(30) Priority: 20.06.2016 JP 2016122102
(43) Date of publication of application: 19.12.2018
(73) Proprietor: Mitsubishi Heavy Industries Thermal Systems, Ltd., Tokyo 108-8215 (JP)
(72) Inventor: TAKAHASHI, Wataru, Tokyo 108-8215 (JP)
(74) Representative: Cabinet Beau de Loménie
(86) International application number: PCT/JP2017/022224
(87) International publication number: WO 2017/221814

(56) References cited:
- WO-A1-2015/045252
- JP-A- 2003 097 881
- JP-A- 2003 097 881
- JP-A- 2008 128 540
- JP-A- 2011 007 480
- JP-A- 2011 257 087
- JP-A- 2012 098 008
- JP-A- 2015 127 630
- JP-B2- 5 754 917
- US-A1- 2012 031 132

## Description

### Technical Field

The present invention relates to a refrigerating unit for transportation mounted on a vehicle.

### Background Art

In a refrigerating unit for transportation mounted on a vehicle, a power generated by a generator using a drive force of a traveling engine or power from a commercial power supply drives a compressor or the like. The refrigerating unit for transportation includes a control box which houses a control device (for example, an inverter or an AC/DC converter) controlling a refrigerating device such as the generator or the compressor, and in this case, a heat radiating fin for cooling the control device (the inverter, the AC/DC converter, or the like) which is a heating part is integrally provided in the control box.

For example, as the refrigerating unit for transportation, there is a refrigerating unit for transportation disclosed in PTL 1. PTL 1 discloses a refrigerating unit for transportation which guides exhaust air of a condenser fan to a heat radiating fin integrally formed in an electrical component storage box and cools an inverter or an AC / DC converter housed in the electrical component storage box. Some other examples of refrigeration units for transportation are disclosed in US2012/0031132 and JP2003/097881.

### Citation List

### Patent Literature

[PTL 1] Japanese Patent No. 5754917

### Summary of Invention

### Technical Problem

However, in the refrigerating unit for transportation disclosed in PTL 1, heat exchange is performed between a high-temperature exhaust air of the condenser fan and the heat radiating fin, and thus, in order to secure required heat radiation performance (cooling performance), it is necessary to increase a heat exchange area and a large-sized heat radiating fin should be used. In particular, when a vehicle is stopped, it is not possible to expect a cooling effect of a running wind, and thus, it is necessary to cool the electric component storage box by only the exhaust air of the condenser fan. Assuming such a case, in design of the heat radiating fin, the heat radiating fin needs to be designed so as to be large enough to secure the required heat radiation performance (cooling performance) by only the exhaust air of the condenser fan.

In addition, in the refrigerating unit for transportation disclosed in PTL 1, depending on the shape of an air guide passage, the exhaust air of the condenser fan stagnates and is accumulated around the condenser. Accordingly, a temperature around the condenser increases, a temperature of the exhaust air of the condenser increases, and there is a possibility that cooling performance of the electric component storage box by the heat radiating fin decreases.

The present invention is made in consideration of the above-described circumstances, and an object thereof is to provide a refrigerating unit for transportation capable of reducing a size of the heat radiating fin cooling the control device housed in the control box.

### Solution to Problem

In order to achieve the above-described object, a refrigerating unit for transportation of the present invention adopts the following means.

That is, according to an aspect of the present invention, there is provided a refrigerating unit for transportation as defined in claim 1.

According to this configuration, the outside air can flow through the heat radiating fin for cooling the control device through the air guide passage, and thus, it is possible to cool the control device by heat exchange between the heat radiating fin and the outside air.

In addition, compared to a case where exhaust air of the condenser flows through the heat radiating fin, the outside air having a relatively low temperature flows through the heat radiating fin, and thus, it is possible to cool the control device by a small-sized heat radiating fin.

In addition, the outside air which has passed through the heat radiating fin through the air guide passage is guided to the condenser fan, and thus, the outside air cooling the control device can flow through the heat radiating fin by the condenser fan, and the outside air can flow through the heat radiating fin even in any vehicle traveling state (for example, a vehicle stopped state) so as to cool the control device.

In addition, the condenser fan is used in order to cause the outside air to flow through the heat radiating fin cooling the control device, and thus, it is not necessary to newly provide other fans or the like, and it is possible to decrease the number of parts.

In addition, in the refrigerating unit for transportation according to the aspect of the present invention, the air guide passage may include an intake port through which the outside air is introduced and may be positioned behind the condenser fan, the refrigerating device may be attached to the front surface of the van body, the control box may be disposed on an upper surface of the refrigerating device so as to be separated from the front surface of the van body, and the intake port may be open between the control box and the front surface of the van body.

When the vehicle travels, a high-temperature exhaust air is discharged from a traveling engine. The discharged exhaust air flows the rear side of the vehicle by running wind of the vehicle and rises along the front surface of the van body. However, in the above-described configuration, the refrigerating device is attached to the front surface of the van body, the intake port of the air guide passage is provided above the refrigerating device, and thus, the rising exhaust air is blocked by the refrigerating device, and the exhaust air does not reach the intake port. Accordingly, the exhaust air of the traveling engine is not easily mixed with the outside air sucked from the intake port, and thus, when the vehicle travels, the outside air flowing through the air guide passage can be maintained at a low temperature, and it is possible to suitably cool the control box.

Moreover, in the refrigerating unit for transportation according to the aspect of the present invention, an upper surface of the control box may be lower than an upper surface of the van body.

In the above-described configuration, the upper surface of the control box is lower than the upper surface of the van body. Accordingly, a portion of wind (for example, running wind) from the front of the vehicle toward the rear of the vehicle passes through a portion above the control box and abuts against an upper portion of the front surface of the van body. If the wind abuts against the upper portion of the front surface of the van body, a pressure around the upper portion increases. The intake port is open between the control box and the van body, a pressure difference between the intake port and the discharge port increases, and thus, much outside air can be guided to the air guide passage. Accordingly, much more outside air can flow through the heat radiating fin, much outside air and the heat radiating fin can be heat-exchanged with each other, and thus, it is possible to more suitably cool the control device.

Moreover, in the refrigerating unit for transportation according to the aspect of the present invention, the air guide passage may include an intake port through which the outside air is sucked and may be positioned in front of the condenser fan, and the intake port may be open forward.

In the above-described configuration, the air guide passage is positioned in front of the condenser fan and the intake port is open forward. Accordingly, a dynamic pressure of wind (for example, the running wind of the vehicle) from the front of the vehicle toward the rear of the vehicle is used, and thus, the outside air is easily introduced into the intake port, and much outside air can be introduced to the air guide passage to flow through the heat radiating fin. Accordingly, much outside air and the heat radiating fin can be heat-exchanged, and thus, it is possible to suitably cool the control box.

In addition, when the vehicle travels, a high-temperature exhaust air is discharged from the traveling engine, and thus, the exhaust air flows from the exhaust port toward the rear of the vehicle by the running wind of the vehicle. In the above-described configuration, the air guide passage is positioned in the front portion of the vehicle and the intake port is open forward, and thus, the exhaust air of the traveling engine is not easily mixed with the outside air sucked from the intake port. Accordingly, when the vehicle travels, the outside air flowing through the air guide passage can be maintained at a low temperature, and it is possible to suitably cool the control box.

In addition, in the refrigerating unit for transportation according to the aspect of the present invention, a recessed portion which is recessed upward along the control device may be formed on a lower surface of the control box, the heat radiating fin may be disposed in the recessed portion, and the recessed portion may constitute a portion of the air guide passage.

In the above-described configuration, the recessed portion is formed in the control box, and the heat radiating fin is disposed in the recessed portion. Accordingly, a height of the control box can be set regardless of a height of the heat radiating fin. Therefore, it is possible to suppress the height of the control box, and it is possible to suppress a height of the refrigerating unit for transportation.

In addition, in the above-described configuration, the recessed portion is formed on the lower surface of the control box along the control device, and the recessed portion is recessed upward. Accordingly, in a case where outside air flows through the heat radiating fin, the recessed portion of the control box can be a portion of the air guide passage. Therefore, it is not necessary to newly provide a part such as a duct exclusively for the air guide passage, and it is possible to form the air guide passage while decreasing the number of parts.

In addition, in the refrigerating unit for transportation according to the aspect of the present invention, a plurality of the condenser fans may be provided, and the air guide passage may communicate with each of the plurality of condenser fans.

In the above-described configuration, the air guide passage communicates with the plurality of condenser fans. Accordingly, even in a case where one condenser fan is failed, outside air can be guided from the intake port to the air guide passage by the other condenser fan to cool the control device.

Moreover, in the refrigerating unit for transportation according to the aspect of the present invention, the air guide passage may be formed by an air guide plate, and the air guide plate may extend to the vicinity of the condenser fan.

In the above-described configuration, the air guide plate forming the air guide passage extends to the vicinity of the condenser fan. Accordingly, it is possible to introduce the outside air to the air guide passage and guide the outside air to the heat radiating fin more reliably so as to cool the control device. Advantageous Effects of Invention

According to the present invention, it is possible to reduce the size of the heat radiating fin which cools the control device housed in the control box.

### Brief Description of Drawings

Fig. 1 is a side view of a vehicle on which a refrigerating unit for transportation according to a first embodiment is mounted.
Fig. 2 is a plan view of Fig. 1.
Fig. 3 is a schematic side view of the refrigerating unit for transportation according to the first embodiment.
Fig. 4 is a schematic perspective view of a control box according to the first embodiment.
Fig. 5 is a schematic perspective view showing a main portion of the refrigerating unit for transportation according to the first embodiment.
Fig. 6 is a schematic side view of a refrigerating unit for transportation according to a second embodiment. Description of Embodiments

Hereinafter, embodiments according to the present invention will be described with reference to the drawings.

### [First Embodiment]

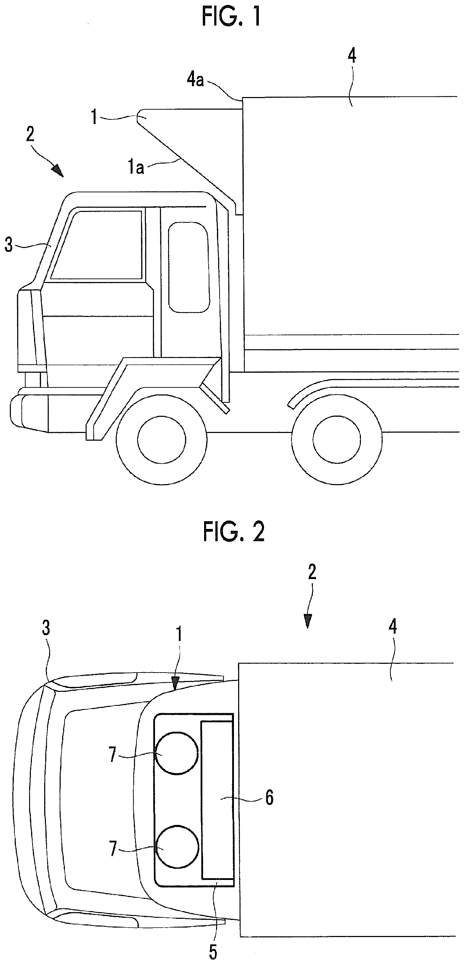

Hereinafter, a first embodiment of the present invention will be described with reference to Figs. 1 to 5.

As shown in Figs. 1 and 2, a vehicle 2 on which a refrigerating unit for transportation 1 according to the present embodiment is mounted is a transportation truck in which a traveling engine (not shown) is disposed below a cab 3. The cab 3 is rotatable by a predetermined angle about a shaft (not shown) extending in a vehicle width direction at a lower portion of a front end. In the vehicle 2, a van body 4 is mounted on a frame which extends in a front-rear direction behind the cab 3. Loads such as frozen and refrigerated items are loaded in the van body 4.

As shown in Figs. 1 and 2, the refrigerating unit for transportation 1 is provided on an upper portion of a front surface 4a of the van body 4 so as to protrude to a portion above the cab 3 over an approximately entire region in the vehicle width direction. The refrigerating unit for transportation 1 supplies generated cool air into the van body 4 so as to maintain a temperature in the van body 4 to a constant temperature.

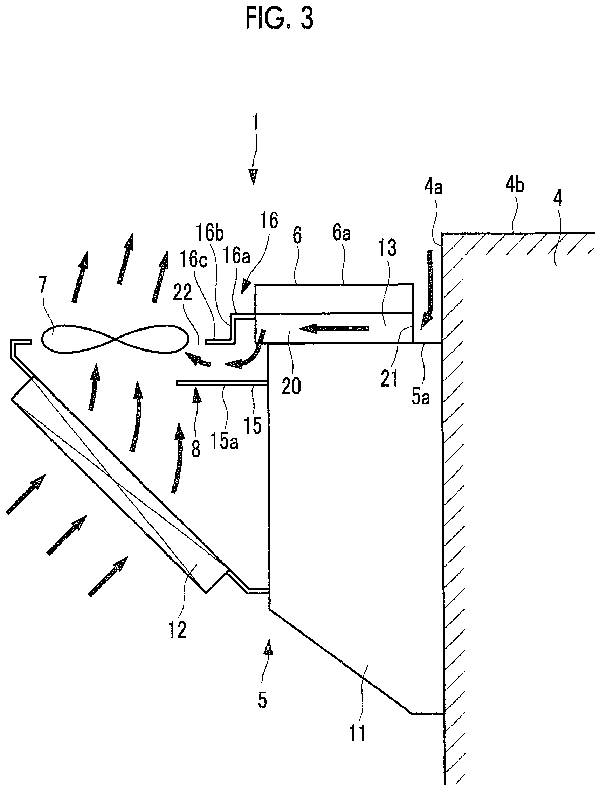

As shown in Figs. 1 and 3, the refrigerating unit for transportation 1 includes a refrigerating device 5 which is fixed to the van body 4, a control box 6 which is installed on an upper surface 5a of the refrigerating device 5, and an air guide portion 8 which forms a portion of an air guide passage 20 described later. The refrigerating unit for transportation 1 has an approximately right triangle shape when viewed from a side, and a front surface 1a is inclined so that a length thereof in the front-rear direction decreases from an upper side to a lower side. That is, the shape of the refrigerating unit for transportation 1 1 is made such that the cab 3 and the refrigerating unit for transportation 1 do not interfere with each other when the above-described cab 3 is rotated. A plurality of air holes through which air is introduced into the refrigerating unit for transportation 1 are formed on the front surface 1a of the refrigerating unit for transportation 1.

The refrigerating device 5 is attached to the front surface 4a of the van body 4, and includes two condenser fans 7 which are provided to be arranged right and left in front of an electric compressor (not shown), an evaporator (not shown), and the control box 6, a refrigerating device body portion 11 in which a generator (not shown) generating electricity by a drive force of the traveling engine or the like is accommodated, and a condenser 12 which is positioned in front of the refrigerating device body portion 11 and is disposed along the front surface 1a of the refrigerating unit for transportation 1. The electric compressor, the evaporator, or the like disposed inside the refrigerating device body portion 11 and the condenser 12 are connected to each other via a refrigerant pipe (not shown), and constitute a refrigerating cycle.

The two condenser fans 7 are disposed such that they are arranged in the vehicle width direction above the condenser 12 and in front of the control box 6 (refer to Figs. 2 and 3) and are rotated about vertical axes of the vehicle so as to discharge air inside the refrigerating unit for transportation 1 to the outside.

The control box 6 has an approximately rectangular box shape extending in the vehicle width direction, and is disposed on an upper surface of the refrigerating device body portion 11 such that that a rear surface of the control box 6 and the front surface 4a of the van body 4 are separated from each other. A front end of the control box 6 is positioned in front of a front end of the refrigerating device 5. An upper surface 6a of the control box 6 is lower than an upper surface 4b of the van body 4. A control device (not shown) is housed inside the control box 6, and the control device controls the refrigerating device 5 such as an inverter device and an AC/DC converter (for example, a three-phase full wave rectifier using a diode).

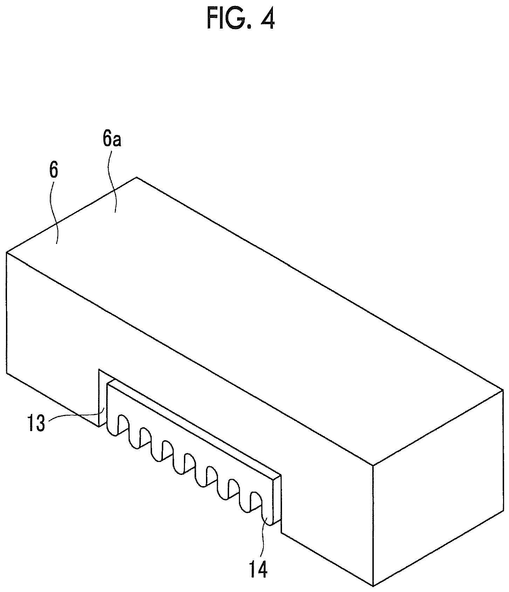

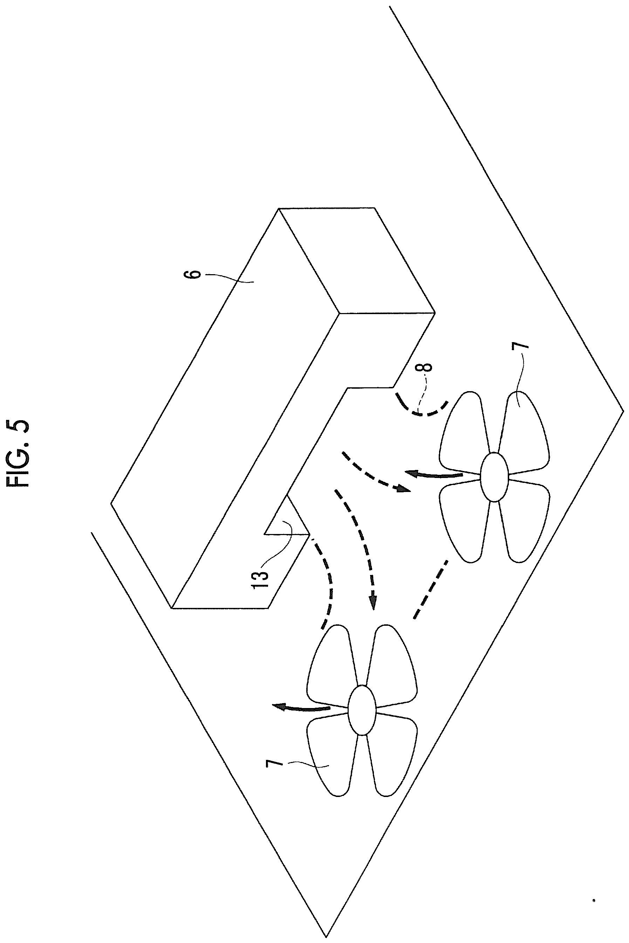

The control box 6 is formed of an aluminum alloy or the like which is lightweight and has improved heat conductivity. Moreover, as shown in Figs. 4 and 5, a recessed portion 13 which extends in the front-rear direction and is recessed upward is formed on a lower surface at an approximately center of the control box 6 in the vehicle width direction over the entire region in the front-rear direction. In the recessed portion 13, a heat radiating fin 14 for cooling a heating part such as an inverter device and an AC/DC converter housed in the control box 6 is integrally provided with the control box 6. The heat radiating fin 14 is a flat plate shape extending in the vehicular front-rear direction (that is, a direction in which the recessed portion 13 extends) and is formed of an aluminum alloy having improved heat conductivity. In addition, a raw material of each of the control box 6 and the heat radiating fin 14 is not limited to the aluminum alloy. For example, the control box may be formed of a steel plate having iron as a raw material. In addition, in Fig. 5, the heat radiating fin 14 (refer to Fig. 4) is not shown.

As shown in Fig. 3, the air guide portion 8 includes a first air guide plate 15 which extends forward from an upper front surface of the refrigerating device 5, and a second air guide plate 16 which extend forward from an upper surface of the recessed portion 13 of the control box 6. The first air guide plate 15 includes a flat plate-shaped lower surface portion 15a, and side surface portions (not show) which are erected upward from both ends of the lower surface portion 15a in the vehicle width direction.

The second air guide plate 16 includes a first horizontal portion 16a which extends forward from the upper surface of the recessed portion 13, a vertical portion 16b which extend downward from a front end of the first horizontal portion 16a, and a second horizontal portion 16c which extends forward from the vertical portion 16b. Both ends of the first horizontal portion 16a, the vertical portion 16b, and the second horizontal portion 16c in the vehicle width direction are connected to upper ends of the side surface portions. That is, a duct-shaped closed space is formed inside by the first air guide plate 15 and the second air guide plate 16.

In addition, in the air guide portion 8, as partially shown by a broken line in Fig. 5, both end portions of the air guide portion 8 in the vehicle width direction are curved or inclined such that the width of the air guide portion 8 in the vehicle width direction increases forward. A right front end and a left front end of the air guide portion 8 are respectively installed around the condenser fans 7 provided right and left, and openings are formed on the right front end and the left front end of the air guide portion 8. That is, air guide portion 8 is open to face the entireties in the vehicle width direction of the condenser fans 7 arranged right and left.

The air guide passage 20 formed by the recessed portion 13 of the control box 6 and the air guide portion 8 will be described. As described above, the recessed portion 13 is formed such that the lower surface of the control box 6 installed on the upper surface 5a of the refrigerating device 5 is recessed upward and is formed to extend in the front-rear direction over the entire region of the control box 6 in the front-rear direction. In addition, the control box 6 is disposed so as to be separated from the van body 4 positioned behind the control box 6. Accordingly, the recessed portion 13 has a duct structure which has openings in a front end portion and a rear end portion thereof and extends in the front-rear direction.

The above-described air guide portion 8 extends to the vicinities of the condenser fans 7 in a duct shape from the front end portion of the recessed portion 13. Accordingly, the recessed portion 13 and the air guide portion 8 are connected to each other, and thus, the air guide passage 20 is formed in which the recessed portion 13 is set to an upstream portion and the air guide portion 8 is a downstream portion. In the air guide passage 20, the rear end portion of the recessed portion 13 is set to an intake port 21 through which outside air is introduced into the air guide passage 20 and openings formed on the right front end and the left front end of the air guide portion 8 are set to a discharge port 22 through which the introduced air is discharged. The end portion of the first air guide plate 15 on the discharge port 22 side extends to a portion vertically below a wing portion of the condenser fan 7.

Next, a flow of air passing through the refrigerating unit for transportation 1 will be described. As shown by solid arrows and dashed arrows in Figs. 3 and 5, if the condenser fans 7 are driven, outside air around the front surface of the refrigerating unit for transportation 1 passes through air holes formed on the front surface of the refrigerating unit for transportation 1 and the condenser 12, and thereafter, is discharged from the condenser fans 7 to the outside of the refrigerating unit for transportation 1. In addition, if the condenser fans 7 are driven, air around the discharge port 22 is sucked to the condenser fan 7 side, and thus, a flow is formed in the air guide passage 20. Accordingly, outside air around the upper surface of the refrigerating unit for transportation 1 is guided to a space between the van body 4 and the control box 6, flows from the intake port 21 of the rear end portion of the control box 6 into the air guide passage 20, and is discharged from the discharge port 22. The outside air discharged from the discharge port 22 is guided upward as it is (refer to Figs. 3 and 5) and is discharged from the condenser fans 7 to the outside of the refrigerating unit for transportation 1.

According to the present embodiment, the following effects are exerted.

The outside air flows through the heat radiating fin 14 for cooling the control device in the control box 6 through the air guide passage 20, and thus, it is possible to cool the control device by heat exchange between the heat radiating fin 14 and the outside air.

In addition, compared to a case where exhaust air of the condenser 12 flows through the heat radiating fin 14, the outside air having a relatively low temperature flows through the heat radiating fin 14, and thus, it is possible to cool the control device by a small-sized heat radiating fin 14.

In addition, the outside air which has passed through the heat radiating fin 14 through the air guide passage 20 is guided to the condenser fans 7, and thus, the outside air cooling the control device can flow through the heat radiating fin 14 by the condenser fans 7, and the outside air can flow through the heat radiating fin 14 even in any vehicle traveling state (for example, a vehicle stopped state) so as to cool the control device.

In addition, the condenser fans 7 are used in order to cause the outside air to flow through the heat radiating fin 14 cooling the control device, and thus, it is not necessary to newly provide other fans or the like, and it is possible to decrease the number of parts.

When the vehicle travels, a high-temperature exhaust air is discharged from the traveling engine disposed below the cab 3. The discharged exhaust air flows the rear side of the cab 3 by running wind of the vehicle and rises along the front surface 4a of the van body 4. However, in the above-described configuration, the refrigerating device 5 is attached to the front surface 4a of the van body 4, the air guide passage 20 is provided on the upper surface 5a of the refrigerating device 5 (refer to Fig. 3), and thus, the rising exhaust air is blocked by the refrigerating device 5, and the exhaust air does not reach the air guide passage 20. Accordingly, the exhaust air of the traveling engine is not easily mixed with the outside air sucked from the intake port 21, and thus, when the vehicle travels, the outside air flowing through the air guide passage 20 can be maintained at a low temperature, and it is possible to suitably cool the control device in the control box 6.

The upper surface 6a of the control box 6 is lower than the upper surface 4b of the van body 4 (refer to Fig. 3). Accordingly, a portion of wind (for example, running wind) from the front of the vehicle toward the rear of the vehicle passes through a portion above the control box 6 and abuts against the upper portion of the front surface of the van body 4. If the wind abuts against the upper portion of the front surface of the van body 4, a pressure around the upper portion increases. The intake port 21 is open between the control box 6 and the van body 4, a pressure difference between the intake port 21 and the discharge port 22 increases, and thus, much outside air can be guided to the air guide passage 20. Accordingly, more much outside air can flow through the heat radiating fin 14, much outside air and the heat radiating fin 14 can be heat-exchanged with each other, and thus, it is possible to more suitably cool the control device.

The recessed portion 13 is formed in the control box 6, and the heat radiating fin 14 is disposed in the recessed portion 13 (refer to Fig. 4). Accordingly, a height of the control box 6 can be set regardless of a height of the heat radiating fin 14. Therefore, it is possible to suppress the height of the control box 6, and it is possible to suppress a height of the refrigerating unit for transportation 1.

In addition, it is possible to decrease the height of the control box 6 disposed above the refrigerating device 5, and thus, the refrigerating device 5 can be disposed at a relatively upper portion of the van body 4. An outlet (not shown) through which cool air generated by the refrigerating device 5 is blown to the inside of the van body 4 is provided inside the van body 4. The refrigerating device 5 can be disposed at a relatively upper portion, and thus, the outlet can be disposed at a relatively upper portion in the van body 4. Accordingly, in case where a package is loaded in the van body, it is possible to make it difficult for the outlet and the package interfere with each other.

In addition, the recessed portion 13 is formed on the lower surface of the control box 6 along the control device, and the recessed portion 13 is recessed upward. Accordingly, in a case where outside air flow through the heat radiating fin 14, the recessed portion 13 of the control box 6 can be a portion of the air guide passage 20. Therefore, it is not necessary to newly provide a part such as a duct exclusively for the air guide passage, and it is possible to form the air guide passage 20 while decreasing the number of parts.

The two condenser fans 7 are provided and the air guide passage 20 extends to the vicinity of each of the condenser fans 7 (refer to Fig. 5). Accordingly, even in a case where one condenser fan 7 is failed, outside air can be guided from the intake port 21 to the air guide passage 20 by the other condenser fan 7 to cool the control device.

The first air guide plate 15 and the second air guide plate 16 forming the air guide passage 20 extend to the vicinity of each of the condenser fans 7. Accordingly, it is possible to introduce the outside air to the air guide passage 20 and guide the outside air to the heat radiating fin 14 more reliably so as to cool the control device.

In addition, in the present embodiment, the first air guide plate 15 extends to the portion vertically below each condenser fan 7. However, the first air guide plate 15 may not extend to the portion vertically below the condenser fan 7. The first air guide plate or the second air guide plate 16 may not extend to the vicinity of each condenser fan 7. Preferably, the vicinity is within 50 mm from an end of the wing portion of the condenser fan 7 in a plan view.

Moreover, in the present embodiment, the front end of the control box 6 is positioned in front of the front end of the refrigerating device 5. A positional relationship between the control box 6 and the refrigerating device 5 is not limited to this. The front end of the control box 6 may be aligned with the front end of the refrigerating device 5 or the front end of the control box 6 may be positioned behind the front end of the refrigerating device 5. Even in the case, the first horizontal portion 16a of the second air guide plate 16 extends forward from the upper surface of the recessed portion 13 formed in the control box 6, and thus, the first horizontal portion 16a further extends than the configuration described in the present embodiment (the configuration in which the front end of the control box 6 is positioned in front of the front end of the refrigerating device 5) so as to form the air guide passage 20.

### [Second Embodiment]

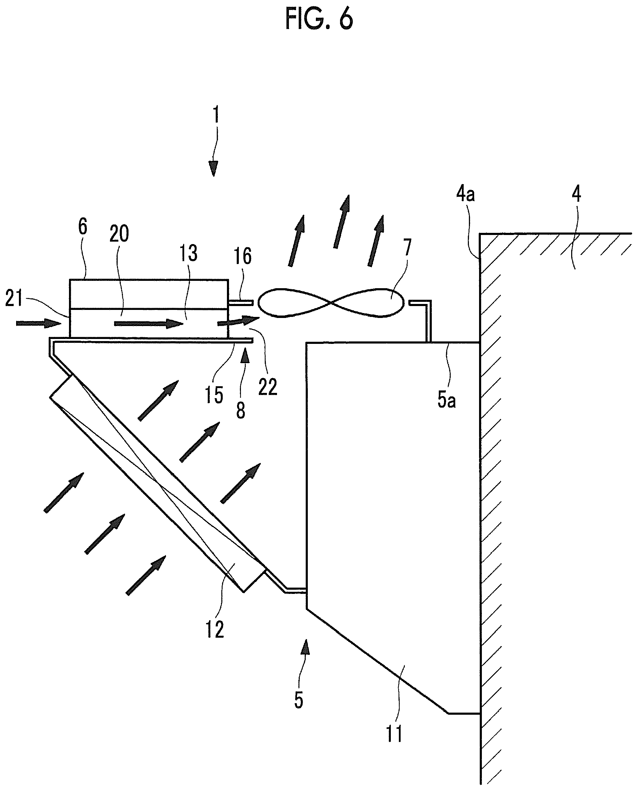

Next, a second embodiment of the present invention will be described with reference to Fig. 6.

Compared to the above-described first embodiment, in the present embodiment, a disposition between the control box 6, the condenser fan 7, and the air guide portion 8 or the like is different. Descriptions of matters similar to those of the first embodiment are omitted.

As shown in Fig. 6, in the refrigerating unit for transportation 1 according to the present embodiment, the condenser fan 7 is disposed above the refrigerating device 5 and the control box 6 is disposed in front of the condenser fan 7. In addition, the air guide portion 8 according to the present embodiment includes the first air guide plate 15 which extends rearward from the lower surface of the control box 6 and a second air guide plate 16 which extends to be approximately parallel to the first air guide plate 15 rearward from the upper surface of the recessed portion 13. Both end portions of the first air guide plate 15 in the vehicle width direction are erected upward and are connected to the second air guide plate 16 at the upper end portions.

A flow of air passing through the refrigerating unit for transportation 1 according to the present embodiment will be described. As shown by arrows in Fig. 6, if the condenser fan 7 is driven, the outside air around the front surface of the refrigerating unit for transportation 1 passes through the air holes formed on the front surface of the refrigerating unit for transportation 1 and the condenser 12, and thereafter, is guided obliquely rearward and upward, and is discharged from the condenser fan 7 to the outside of the refrigerating unit for transportation 1. In addition, if the condenser fan 7 is driven, the outside air around the front surface of the control box 6 flows from the intake port 21 of the front surface of the control box into the air guide passage 20 and is discharged from the discharge port 22. The outside air discharged from the discharge port 22 is guided upward as it is and is discharged from the condenser fan 7 to the outside of the refrigerating unit for transportation 1.

According to the present embodiment, the following effects are exerted.

The air guide passage 20 is positioned in front of the condenser fan 7 and the intake port 21 is open forward. Accordingly, a dynamic pressure of wind (for example, the running wind of the vehicle) from the front of the vehicle toward the rear of the vehicle is used, and thus, the outside air is easily introduced into the intake port 21, and much outside air can be introduced to the air guide passage to flow through the heat radiating fin 14. Accordingly, much outside air and the heat radiating fin 14 can be heat-exchanged, and thus, it is possible to suitably cool the control box 6.

In addition, when the vehicle travels, a high-temperature exhaust air is discharged from the traveling engine, and thus, the exhaust air flows from the exhaust port toward the rear of the vehicle by the running wind of the vehicle. In the above-described configuration, the air guide passage 20 is positioned in the front portion of the vehicle 2 and the intake port 21 is open forward, and thus, the exhaust air of the traveling engine is not easily mixed with the outside air sucked from the intake port 21. Accordingly, when the vehicle travels, the outside air flowing through the air guide passage 20 can be maintained at a low temperature, and it is possible to suitably cool the control box 6.

Moreover, the present invention is not limited to the inventions according to the above-described first embodiment and second embodiment, and can be appropriately modified within a scope which does not depart from the gist. For example, in the above-described first and second embodiments, two condenser fans 7 are provided. However, the number of the condenser fans 7 may be one or three or more.

### Reference Signs List

- 1:: refrigerating unit for transportation
- 4:: van body
- 5:: refrigerating device
- 6:: control box
- 7:: condenser fan
- 8:: air guide portion
- 12:: condenser
- 13:: recessed portion
- 14:: heat radiating fin
- 15:: first air guide plate
- 16:: second air guide plate
- 20:: air guide passage
- 21:: intake port
- 22:: discharge port

## Claims

1. A refrigerating unit for transportation (1) comprising:
a refrigerating device (5) which is adapted to be attached to a front surface of a van body (4) and includes a condenser (12) and a condenser fan (7) configured to discharge air which has passed through the condenser (12);
a control device configured to control the refrigerating device (5);
a control box (6) which includes a heat radiating fin (14) for cooling the control device on an outer surface of the control box (6) and houses the control device; and
an air guide passage (20) through which outside air is guided to the heat radiating fin (14) and outside air which has passed through the heat radiating fin (14) is guided to an intake side of the condenser fan (7),
**characterized in that** the control box (6) is disposed on an upper surface of the refrigeration device (5),
wherein a recessed portion (13) which is recessed upward along the control device is formed on a lower surface of the control box (6),
wherein the heat radiating fin (14) is disposed in the recessed portion (13) and
wherein the recessed portion (13) constitutes a portion of the air guide passage (20).

2. The refrigerating unit for transportation (1) according to claim 1,
wherein the air guide passage (20) includes an intake port (21) through which the outside air is introduced and is positioned behind the condenser fan (7) in a vehicle front-rear direction when the refrigeration unit is attached to the van body (4), wherein the control box (6) is disposed so as to be separated from the front surface of the van body (4), and
wherein the intake port (21) is open between the control box (6) and the front surface of the van body (4).

3. The refrigerating unit for transportation (1) according to claim 2,
wherein an upper surface of the control box (6) is lower than an upper surface of the van body.

4. The refrigerating unit for transportation (1) according to claim 1,
wherein the air guide passage (20) includes an intake port (21) through which the outside air is sucked and is positioned in front of the condenser fan (7), and
wherein the intake port (21) is open forward in a vehicle front-rear direction when the refrigeration unit is attached to the van body (4).

5. The refrigerating unit for transportation (1) according to any one of claims 1 to 4,
wherein a plurality of the condenser fans (7) are provided, and
wherein the air guide passage (20) communicates with each of the plurality of condenser fans (7).

6. The refrigerating unit for transportation (1) according to any one of claims 1 to 5,
wherein the air guide passage (20) is formed by an air guide plate(15, 16), and
wherein the air guide plate (15, 16) extends to the vicinity of the condenser fan (7).

## Patentansprüche

1. Kälteeinheit für den Transport (1), die Folgendes umfasst:
eine Kältevorrichtung (5), die angepasst ist, an einer vorderen Fläche eines Lastwagenaufbaus (4) befestigt zu werden, und einen Verflüssiger (12) und einen Verflüssigerlüfter (7), der dazu ausgelegt ist, Luft, die durch den Verflüssiger (12) geleitet wurde, auszugeben, beinhaltet;
eine Steuervorrichtung, die dazu ausgelegt ist, die Kältevorrichtung (5) zu steuern;
eine Steuerbox (6), die eine Wärmeabstrahlrippe (14) zum Kühlen der Steuervorrichtung an einer Außenfläche der Steuerbox (6) beinhaltet und die Steuervorrichtung umschließt; und
einen Luftführungskanal (20), durch den Außenluft zur Wärmeabstrahlrippe (14) geführt wird und Außenluft, die durch die Wärmeabstrahlrippe (14) geleitet wurde, zu einer Einlassseite des Verflüssigerlüfters (7) geführt wird,
**dadurch gekennzeichnet, dass** die Steuerbox (6) auf einer oberen Fläche der Kältevorrichtung (5) angeordnet ist,
wobei ein vertiefter Abschnitt (13), der entlang der Steuervorrichtung nach oben vertieft ist, auf einer unteren Fläche der Steuerbox (6) gebildet ist,
wobei die Wärmeabstrahlrippe (14) im vertieften Abschnitt (13) angeordnet ist, und
wobei der vertiefte Abschnitt (13) einen Abschnitt des Luftführungskanals (20) konstituiert.

2. Kälteeinheit für den Transport (1) nach Anspruch 1,
wobei der Luftführungskanal (20) einen Einlassanschluss (21) beinhaltet, durch den die Außenluft eingeleitet wird, und in einer Vorn-Hinten-Fahrzeugrichtung hinter dem Verflüssigerlüfter (7) positioniert ist, wenn die Kälteeinheit am Lastwagenaufbau (4) befestigt ist,
wobei die Steuerbox (6) angeordnet ist, um von der vorderen Fläche des Lastwagenaufbaus (4) getrennt zu sein, und
wobei der Einlassanschluss (21) zwischen der Steuerbox (6) und der vorderen Fläche des Lastwagenaufbaus (4) offen ist.

3. Kälteeinheit für den Transport (1) nach Anspruch 2,
wobei eine obere Fläche der Steuerbox (6) niedriger ist als eine obere Fläche des Lastwagenaufbaus.

4. Kälteeinheit für den Transport (1) nach Anspruch 1,
wobei der Luftführungskanal (20) einen Einlassanschluss (21) beinhaltet, durch den die Außenluft angesaugt wird, und vor dem Verflüssigerlüfter (7) positioniert ist, und
wobei der Einlassanschluss (21) in einer Vorn-Hinten-Fahrzeugrichtung nach vorn offen ist, wenn die Kälteeinheit am Lastwagenaufbau (4) befestigt ist.

5. Kälteeinheit für den Transport (1) nach einem der Ansprüche 1 bis 4,
wobei eine Vielzahl von Verflüssigerlüftern (7) bereitgestellt sind, und
wobei der Luftführungskanal (20) mit jedem der Vielzahl von Verflüssigerlüftern (7) kommuniziert.

6. Kälteeinheit für den Transport (1) nach einem der Ansprüche 1 bis 5,
wobei der Luftführungskanal (20) durch eine Luftführungsplatte (15, 16) gebildet wird, und
wobei sich die Luftführungsplatte (15, 16) in die Nähe des Verflüssigerlüfters (7) erstreckt.

## Revendications

1. Unité frigorifique pour le transport (1) comprenant :
un dispositif de réfrigération (5) qui est adapté pour être fixé sur une surface avant d'un corps de camionnette (4) et comprend un condensateur (12) et un ventilateur de condensateur (7) configuré pour décharger l'air qui est passé à travers le condensateur (12) ;
un dispositif de commande configuré pour commander le dispositif de réfrigération (5) ;
une boîte de commande (6) qui comprend une ailette de rayonnement de chaleur (14) pour refroidir le dispositif de commande sur une surface externe de la boîte de commande (6) et loge le dispositif de commande ; et
un passage de guidage d'air (20) à travers lequel l'air extérieur est guidé vers l'ailette de rayonnement de chaleur (14) et l'air extérieur qui est passé par l'ailette de rayonnement de chaleur (14) est guidé vers un côté d'admission du ventilateur de condensateur (7),
**caractérisée en ce que** :
la boîte de commande (6) est disposée sur une surface supérieure du dispositif de réfrigération (5),
dans laquelle une partie évidée (13) qui est évidée vers le haut le long du dispositif de commande, est formée sur une surface inférieure de la boîte de commande (6),
dans laquelle l'ailette de rayonnement de chaleur (14) est disposée dans la partie évidée (13), et
dans laquelle la partie évidée (13) constitue une partie du passage de guidage d'air (20).

2. Unité frigorifique pour le transport (1) selon la revendication 1,
dans laquelle le passage de guidage d'air (20) comprend un orifice d'admission (21) à travers lequel l'air extérieur est introduit et est positionné derrière le ventilateur de condensateur (7) dans une direction avant-arrière du véhicule lorsque l'unité frigorifique est fixée sur le corps de camionnette (4),
dans laquelle la boîte de commande (6) est disposée afin d'être séparée de la surface avant du corps de camionnette (4), et
dans laquelle l'orifice d'admission (21) est ouvert entre la boîte de commande (6) et la surface avant du corps de camionnette (4).

3. Unité frigorifique pour le transport (1) selon la revendication 2,
dans laquelle une surface supérieure de la boîte de commande (6) est plus basse qu'une surface supérieure du corps de camionnette.

4. Unité frigorifique pour le transport (1) selon la revendication 1,
dans laquelle le passage de guidage d'air (20) comprend un orifice d'admission (21) à travers lequel l'air extérieur est aspiré et est positionné en face du ventilateur de condensateur (7), et
dans laquelle l'orifice d'admission (21) est ouvert vers l'avant dans une direction avant-arrière du véhicule lorsque l'unité frigorifique est fixée au corps de camionnette (4).

5. Unité frigorifique pour le transport (1) selon l'une quelconque des revendications 1 à 4,
dans laquelle on prévoit une pluralité de ventilateurs de condensateur (7), et
dans laquelle le passage de guidage d'air (20) communique avec chacun de la pluralité de ventilateurs de condensateur (7).

6. Unité frigorifique pour le transport (1) selon l'une quelconque des revendications 1 à 5,
dans laquelle le passage de guidage d'air (20) est formé par une plaque de guidage d'air (15, 16), et
dans laquelle la plaque de guidage d'air (15, 16) s'étend à proximité du ventilateur de condensateur (7).
